## Europäisches Patentamt

## European Patent Office

## Office européen des brevets

(19)

(11) **EP 1 289 026 A2**

(12) **EUROPÄISCHE PATENTANMELDUNG**

(43) Veröffentlichungstag:
**05.03.2003 Patentblatt 2003/10**

(51) Int Cl.7: **H01L 35/16**

(21) Anmeldenummer: **02018298.6**

(22) Anmeldetag: **26.08.2002**

(84) Benannte Vertragsstaaten:
**AT BE BG CH CY CZ DE DK EE ES FI FR GB GR IE IT LI LU MC NL PT SE SK TR**
Benannte Erstreckungsstaaten:
**AL LT LV MK RO SI**

(30) Priorität: **31.08.2001 DE 10142634**
**28.05.2002 DE 10223743**

(71) Anmelder: **BASF AKTIENGESELLSCHAFT**
**67056 Ludwigshafen (DE)**

(72) Erfinder:
• **Sterzel, Hans-Josef, Dr.**
**67125 Dannstadt-Schauernheim (DE)**
• **Kühling, Klaus, Dr.**
**67112 Mutterstadt (DE)**

(74) Vertreter: **Isenbruck, Günter, Dr. et al**
**Isenbruck, Bösl, Hörschler, Wichmann, Huhn,**
**Patentanwälte**
**Theodor-Heuss-Anlage 12**
**68165 Mannheim (DE)**

(54) **Thermoelektrisch aktive Materialien und diese enthaltende Generatoren und Peltier-Anordnungen**

(57) In einem thermoelektrischen Generator oder Peltier-Anordnung mit einem thermoelektrisch aktiven Halbleitermaterial aus mehreren Metallen oder Metalloxiden, ist das thermoelektrisch aktive Material ausgewählt aus einem p- oder n-dotierten Halbleitermaterial aus einer ternären Verbindung der allgemeinen Formel (I)

$$Me_x S^A_y S^B_z \qquad (I)$$

mit

Me = Al, Ti, Zr, V, Nb, Ta, Cr, Mo, W, Mn, Fe, Co, Ni, Cu oder Ag,

$S^A$, $S^B$ = B, C, Si, Ge, Sb, Se oder Te,

wobei $S^A$ und $S^B$ jeweils aus verschiedenen Gruppen des Periodensystems der Elemente stammen,
x, y, z unabhängig voneinander Werte von 0,01 bis 1 haben,und wobei der Gewichtsanteil von $S^A$ und $S^B$ zusammen mehr als 30 % beträgt, bezogen auf das gesamte Halbleitermaterial,
ausgenommen ternäre Verbindungen aus $AlB_{12}$ und $SiB_6$,
oder einem Mischoxid der allgemeinen Formel (II)

$$[(CaO)_u \cdot (SrO)_v \cdot (BaO)_w \cdot (1/2\ Bi_2O_3)_x]_f \cdot \frac{2n+a}{2}(\{k\} \cdot Me^n O_{\frac{n}{2}} \cdot \{2-k\} \cdot Me^{n+a} O_{\frac{n+a}{2}}) \qquad (II)$$

mit

Me = Fe, Cu, V, Mn, Sn, Ti, Mo, W

n = ganze Zahl von 1 bis 6,

a = 1 oder 2,

f = Zahl von 0,2 bis 5,

k = Zahl von 0,01 bis 2,

$$u+v+w+x= 1.$$

**Beschreibung**

Die Erfindung betrifft thermoelektrische aktive Materialien und diese enthaltende Generatoren sowie Peltier-Anordnungen.

Thermoelektrische Generatoren als solche sind seit langem bekannt. p- und n-dotierte Halbleiter, die auf einer Seite erhitzt und auf der anderen Seite gekühlt werden, transportieren elektrische Ladungen durch einen äußeren Stromkreis, an einem Verbraucher im Stromkreis wird dabei elektrische Arbeit verrichtet. Der dabei erzielte Wirkungsgrad der Konversion von Wärme in elektrische Energie wird thermodynamisch durch den Carnot-Wirkungsgrad limitiert. Somit wäre bei einer Temperatur von 1000 K auf der heißen und 400 K auf der "kalten" Seite ein Wirkungsgrad von (1000 - 400) : 1000 = 60 % möglich. Leider werden bis heute nur Wirkungsgrade bis 10 % erzielt.

Legt man andererseits einen Gleichstrom an eine derartige Anordnung an, so wird Wärme von einer Seite zur anderen transportiert. Eine derartige Peltier-Anordnung arbeitet als Wärmepumpe und eignet sich deshalb zur Kühlung von Apparateteilen, Fahrzeugen oder Gebäuden. Auch die Heizung über das Peltier-Prinzip ist günstiger als eine übliche Heizung, weil immer mehr Wärme transportiert wird als dem zugeführten Energie-äquivalent entspricht.

Einen guten Überblick über Effekte und Materialien gibt z.B. Cronin B. Vining, ITS Short Course on Thermoelectricity, Nov. 8, 1993, Yokohama, Japan.

Gegenwärtig werden thermoelektrische Generatoren in Raumsonden zur Erzeugung von Gleichströmen, für den kathodischen Korrosionsschutz von Pipelines, zur Energieversorgung von Leucht- und Funkbojen, zum Betrieb von Radios und Fernsehapparaten eingesetzt. Die Vorteile der thermoelektrischen Generatoren liegen in ihrer äußersten Zuverlässigkeit, sie arbeiten unabhängig von atmosphärischen Bedingungen wie Luftfeuchte, es erfolgt kein störungsanfälliger Stofftransport, sondern nur ein Ladungstransport; der Betriebsstoff wird kontinuierlich - auch katalytisch ohne freie Flamme - verbrannt, wodurch geringe Mengen an CO, $NO_x$ und unverbranntem Betriebsstoff frei werden; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

Damit paßt sich die thermoelektrische Energiewandlung äußerst flexibel in künftige Bedürfnisse wie Wasserstoffwirtschaft oder Energieerzeugung aus regenerativen Energien ein.

Eine besonders attraktive Anwendung wäre der Einsatz zur Wandlung in elektrische Energie in elektrisch betriebenen Fahrzeugen. Es brauchte keine Änderung am vorhandenen Tankstellennetz vorgenommen zu werden. Für eine derartige Anwendung wären jedoch Wirkungsgrade größer als 30 % notwendig.

Auch die Umwandlung solarer Energie direkt in elektrische Energie wäre sehr attraktiv. Konzentratoren wie Parabolrinnen können mit Wirkungsgraden um 95 - 97 % die Sonnenenergie auf thermoelektrische Generatoren bündeln, und so kann elektrische Energie erzeugt werden.

Aber auch zur Nutzung als Wärmepumpe sind höhere Wirkungsgrade notwendig.

Die Aufgabe der Erfindung besteht deshalb darin, thermoelektrische aktive Materialien zur Verfügung zu stellen, die höhere Wirkungsgrade als bisher ermöglichen. Kennzeichnend für thermoelektrische Materialien ist der sogenannte Z-Faktor (figure of merit)

$$Z = \frac{\alpha^2 * \sigma}{K}$$

mit dem Seebeck-Koeffizienten $\alpha$, der elektrischen Leitfähigkeit $\sigma$ und der Wärmeleitfähigkeit K.

Eine genauere Analyse ergibt, dass der Wirkungsgrad sich ergibt aus $\eta$

$$\eta = \frac{T_{hoch} - T_{niedrig}}{T_{hoch}} * \frac{M - 1}{M + \frac{T_{hoch}}{T_{niedrig}}}$$

mit M = $[1 + Z/2 (T_{hoch} - T_{niedrig})]1/2$
(siehe auch Mat. Sci. and Eng. B29 (1995) 228).

Das Ziel ist damit, ein Material mit einem möglichst hohen Wert für Z und hoher realisierbarer Temperaturdifferenz bereitzustellen. Aus der Sicht der Festkörperphysik sind hierbei viele Probleme zu bewältigen:

Ein hohes $\alpha$ bedingt eine hohe Elektronenbeweglichkeit im Material; d.h. Elektronen (oder Löcher bei p-leitenden Materialien) dürfen nicht stark an die Atomrümpfe gebunden sein. Materialien mit hoher elektrischer Leitfähigkeit weisen meist gleichzeitig eine hohe Wärmeleitfähigkeit auf (Wiedemann - Franzsches Gesetz), wodurch Z nicht günstig beeinflußt werden kann. Gegenwärtig eingesetzte Materialien wie $Bi_2Te_3$, PbTe oder SiGe stellen schon Kompromisse dar. So wird die elektrische Leitfähigkeit durch Legieren weniger herabgesetzt als die Wärmeleitfähigkeit.

Deshalb setzt man vorzugsweise Legierungen ein wie z.B. $(Bi_2Te_3)_{90}$ $(Sb_2Te_3)_5$ $(Sb_2Se_3)_5$ oder $Bi_{12}Sb_{23}Te_{65}$, wie sie in der US 5,448,109 beschrieben sind.

Für thermoelektrische Materialien mit hohem Wirkungsgrad sind vorzugsweise noch weitere Randbedingungen zu erfüllen. Vor allem müssen sie temperaturstabil sein, um bei Arbeitstemperaturen von 1000 bis 1500 K über Jahre ohne wesentlichen Wirkungsgradverlust arbeiten zu können. Dies bedingt sowohl hochtemperaturstabile Phasen an sich, eine stabile Phasenzusammensetzung, wie auch eine zu vernachlässigende Diffusion von Legierungsbestandteilen in die anliegenden Kontaktmaterialien.

In der neueren Patentliteratur finden sich Beschreibungen von thermoelektrischen Materialien beispielsweise in US 6,225,550 und EP-A-1 102 334. Die US 6,225,550 betrifft im wesentlichen Materialien aus $Mg_xSb_z$, die weiterhin mit einem weiteren Element, vorzugsweise einem Übergangsmetall, dotiert sind.

Die EP-A-1 102 334 offenbart p- oder n-dotierte Halbleitermaterialien, die ein mindestens ternäres Material darstellen aus den Stoffklassen der Silizide, Boride, Germanide, Telluride, Sulfide und Selenide, Antimonide, Plumbide und halbleitenden Oxiden.

Es besteht jedoch weiterhin Bedarf an thermoelektrisch aktiven Materialien, die einen hohen Wirkungsgrad aurweisen und für unterschiedliche Anwendungsbereiche ein geeignetes Eigenschaftsprofil zeigen. Die Forschung auf dem Gebiet der thermoelektrisch aktiven Materialien ist noch in keiner Weise als abgeschlossen zu betrachten, so dass weiterhin Nachfrage nach unterschiedlichen thermoelektrischen Materialien besteht.

Die Aufgabe wird erfindungsgemäß gelöst durch einen thermoelektrischen Generator oder eine Peltier-Anordnung mit einem thermoelektrisch aktiven Halbleitermaterial aus mehreren Metallen oder Metalloxiden, der dadurch gekennzeichnet ist, dass das thermoelektrisch aktive Material ausgewählt ist aus

einem p- oder n-dotierten Halbleitermaterial aus einer ternären Verbindung der allgemeinen Formel (I)

$$Me_x S^A_y S^B_z \qquad\qquad (I)$$

mit
Me = Al, Ti, Zr, V, Nb, Ta, Cr, Mo, W, Mn, Fe, Co, Ni, Cu oder Ag,
$S^A$, $S^B$ = B, C, Si, Ge, Sb, Se oder Te,
wobei $S^A$ und $S^B$ jeweils aus verschiedenen Gruppen des Periodensystems der Elemente stammen,
x, y, z unabhängig voneinander sind und sich im Bereich von 0,01 bis 1 bewegen,
wobei der Gewichtsanteil von $S^A$ und $S^B$ zusammen mehr als 30 % beträgt, bezogen auf das gesamte Halbleitermaterial,
ausgenommen ternäre Verbindungen aus $AlB_{12}$ und $SiB_6$,
oder einem Mischoxid der allgemeinen Formel (II)

$$[(CaO)_u \cdot (SrO)_v \cdot (BaO)_w \cdot (1/2\ Bi_2O_3)_x]_f \cdot \frac{2n+a}{2} \cdot \left(\left\{k\right\}\ Me^n O_{\frac{n}{2}} \cdot \left\{2-k\right\} \cdot Me^{n+a} O_{\frac{n+a}{2}}\right)\ (II)$$

mit
Me = Fe, Cu, V, Mn, Sn, Ti, Mo, W
n = ganze Zahl von 1 bis 6,
a = 1 oder 2,
f = Zahl von 0,2 bis 5,
k = Zahl von 0,01 bis 2, vorzugsweise 0,01 bis 1,99, z.B. 1
u + v + w + x = 1.

Die erfindungsgemäßen thermoelektrischen Generatoren und Peltier-Anordnungen bereichern zum einen ganz allgemein die Palette der verfügbaren thermoelektrischen Generatoren und Peltier-Anordnungen. Durch die unterschiedlichen chemischen Systeme können unterschiedliche Anforderungen in verschiedenen Anwendungsbereichen der thermoelektrischen Generatoren und Peltier-Anordnungen erfüllt werden. Die erfindungsgemäßen thermoelektrischen Generatoren oder Peltier-Anordnungen erweitern damit die Anwendungsmöglichkeiten dieser Elemente unter unterschiedlichen Bedingungen beträchtlich.

Nachstehend werden bevorzugte Halbleitermaterialien näher erläutert.

In den ternären Verbindungen der allgemeinen Formel (I) sind $S^A$ und $S^B$ vorzugsweise ausgewählt aus B, C, Ge, Sb und Te.

Vorzugsweise ist in diesem Halbleitermaterial Me ausgewählt aus einer der folgenden Gruppen:

1) Al, Ti, Zr
2) V, Nb, Ta
3) Cr, Mo, W
4) Mn, Fe, Co, Ni
5) Cu, Ag.

Der Anteil an Dotierungselementen beträgt bis zu 0,1 Atom-% in der Legierung oder $10^{18}$ bis $10^{20}$ Ladungsträger pro Kubikzentimeter. Höhere Ladungsträgerkonzentrationen bewirken nachteilige Rekombinationen und damit eine reduzierte Ladungsbeweglichkeit. Dotiert wird mit Elementen, die einen Elektronenüber- oder -unterschuss im Kristallgitter bewirken, z.B. mit Iod für n-Halbleiter und Erdalkalielementen für p-Halbleiter, sofern ein 3/5- oder 3/6-Halbleiter vorliegt.

Eine weitere Möglichkeit der Dotierung ergibt sich dadurch, dass man gezielt durch unteroder überstöchiometrische Zusammensetzungen Löcher oder Elektronen in die Materialien einbringt und sich damit einen zusätzlichen Dotierschritt erspart.

Dotierelemente können auch über die wässrigen Lösungen von Metallsalzen eingebracht werden, die anschließend in der Mischung getrocknet werden. Anschließend werden die Metallkationen z.B. durch Wasserstoff bei erhöhten Temperaturen reduziert oder verbleiben ohne Reduktion im Material. Bevorzugt erfolgt die p- oder n-Dotierung durch Wahl der Mengenverhältnisse der Verbindungen oder die p-Dotierung mit Alkalimetallen und die n-Dotierung mit Sb, Bi, Se, Te, Br oder I (siehe WO 92/13811).

Die erfindungsgemäßen Materialien der allgemeinen Formel (I) werden nach bekannten Verfahren hergestellt, die Elementverbindungen z.B. durch Sintern der Elementpulver bei hohen Temperaturen, jedoch unterhalb des Schmelzpunkts unter Inertgas wie Argon oder Vakuum, oder durch Schmelzen im Hochvakuum sowie anschließendes Pulverisieren und Sintern oder durch Schmelzen der Mischung der Elementpulver und Abkühlung.

In den Mischoxiden der allgemeinen Formel (II) bedeuten n die Oxidationsstufe des Metalls Me und f einen Stöchiometriefaktor. f hat einen Wert im Bereich von 0,2 bis 5, vorzugsweise von 0,5 bis 2, besonders bevorzugt von 1. a gibt die Differenz der beiden unterschiedlichen Oxidationsstufen von Me an.

Für den Stöchiometriefaktor f können als bevorzugte Bereiche Zahlen von 0,2 bis 0,99, der Wert 1, Zahlen von 1,01 bis 2 und Zahlen von 2,01 bis 5 angegeben werden. Es handelt sich um jeweils bevorzugte Ausführungsformen der Erfindung.

k gibt den Anteil der verschiedenen Oxidationsstufen an.

Der Inhalt der Klammer

$$(\{k\}\ \mathrm{Me^n O}_{\frac{n}{2}} \cdot \{2-k\}\ \mathrm{Me^{n+a} O}_{\frac{n+a}{2}})$$

kann bevorzugt konkret sein:

$FeO\ //\ Fe_2O_3$
$Cu_2O\ //\ CuO$
$VO\ //\ V_2O_3$
$V_2O_3\ //\ V_2O_5$
$VO_2\ //\ V_2O_5$
$VO_2\ //\ V_2O_3$
$MnO\ //\ Mn_2O_3$
$Mn_2O_3\ //\ Mn_2O_3$
$SnO\ //\ SnO_2$
$TiO\ //\ Ti_2O_3$
$Ti_2O_3\ //\ TiO_2$
$MoO_2\ //\ MoO_3$ oder
$WO_2\ //\ WO_3$, insbesondere bevorzugt konkret

$FeO \cdot 1/2\ Fe_2O_3$
$1/2\ Cu_2O \cdot CuO$
$VO \cdot 1/2\ V_2O_3$
$V_2O_3 \cdot V_2O_5$
$VO_2 \cdot 1/2\ V_2O_5$

$VO_2 \cdot 1/2\ V_2O_3$
$MnO \cdot 1/2\ Mn_2O_3$
$Mn_2O_3\ Mn_2O_3$
$SnO \cdot SnO_2$
$TiO \cdot 1/2\ Ti_2O_3$
$1/2\ Ti_2O_3 \cdot TiO_2$
$MoO_2 \cdot MoO_3$ oder
$WO_2 \cdot WO_3$

Die erfindungsgemäßen Mischoxide werden nach bekannten Verfahren hergestellt, vorzugsweise durch inniges Vermischen der Einzeloxide mit den bekannten keramischen Technologien, Pressen der Mischungen unter Druck zu Formlingen von beispielsweise quaderförmiger Gestalt oder Vermischen von Schlickern der Einzeloxide und Eingießen der Schlicker in entsprechende Formen mit nachfolgendem Entfernen des Suspensionsmittels und Sintern der Formlinge in inerter Atmosphäre, z.B. unter Argon, bei Temperaturen von 900 bis 1700 °C.

Die erfindungsgemäßen Materialien werden somit nach bekannten Verfahren hergestellt, die Elementverbindungen z. B. durch Sintern der Elementpulver bei hohen Temperaturen, jedoch unterhalb des Schmelzpunkts oder durch Schmelzen im Hochvakuum sowie anschließendes Pulverisieren und Sintern. Die Oxide werden z. B. durch Sintern der Pulvermischungen der Einzeloxide synthetisiert. Der Ausdruck "kombinatorisch", wie er hier benutzt wird, bezieht sich gerade auf diese Herstellung, insbesondere das Sintern.

Die thermoelektrisch aktiven Mischoxide lassen sich auch durch Reaktivsintern der entsprechenden Metallmischungen in Luft bei erhöhten Temperaturen herstellen. Aus wirtschaftlichen Gründen ist es auch sinnvoll, Mischungen von Oxiden und Metallen einzusetzen.

Ein weiterer Gegenstand der Erfindung ist die Optimierung der Materialien hinsichtlich des Wirkungsgrads. Es liegt auf der Hand, dass bei Variation der Komponenten um beispielsweise 5 Atom-% sehr viele Materialien synthetisiert und geprüft werden müssen. Diese Aufgabe kann mit kombinatorischen Methoden gelöst werden. Dazu können Elementlegierungen oder Oxidmischungen oder Mischungen von Elemente mit Oxiden mit gradueller Variation der Zusammensetzung als Funktion der Längenkoordination auf einem Substrat erzeugt werden, indem man die Elemente oder bereits binäre Legierungen von entsprechenden Targets aus auf einem mit einer Lochmaske versehenen Substrat erzeugt, wobei sich die Elementzusammensetzung je nach Entfernung von den Targets oder je nach Sputterwinkel ändert. Anschließend wird die Maske entfernt, und die erzeugten "Dots" werden zu den eigentlichen Materialien gesintert. Der Ausdruck "Dot" bezeichnet dabei räumlich voneinander getrennte Punkte oder Bereiche des Materials auf einem Substrat, die im wesentlich gleiche Ausmaße aufweisen und vorzugsweise in regelmäßigen Abständen angeordnet sind, so dass sich ein Array ergibt. "Array" bedeutet die zweidimensionale, im wesentlichen gleichmäßig beabstandete Anordnung von Dots auf einer Substratfläche. Es ist auch möglich, Element- und Oxidpulver mit Korngrößen unterhalb 5 µm in einem inerten Suspensionsmittel wie Kohlenwasserstoffen unter Mitwirkung eines Dispergiermittels zu genügend stabilen Suspensionen zu suspendieren und Mischungen der Suspensionen wie bei den Oxiden beschrieben als Tröpfchen abzulegen, das Suspensionsmittel zu verdampfen und die so erzeugte Pulvermischungen auf dem Substrat zu sintern.

Als inertes, temperatur- und diffusionsstabiles Substratmaterial wird neben metallischen Substraten Siliziumcarbid bevorzugt, das auch genügend elektrisch leitfähig ist.

Dots der Oxide können auf einer Substratfläche auf erzeugt werden, indem über Dosierautomaten Mischungen von Salzen, vorzugsweise von Nitraten oder sonstigen löslichen Verbindungen in Form von Tropfen variabler Zusammensetzung abgelegt werden, das Lösungsmittel, vorzugsweise Wasser, verdampft wird, durch Temperaturerhöhung die Nitrate oder Verbindungen in die Oxide überführt werden und die Oxidmischungen in ihrer Gesamtheit anschließend gesintert werden.

Pro Substratplatte mit Maßen von in der Größenordnung $10 * 10\ cm^2$ werden 1.000 bis 10.000 Dots mit Abmessung (Durchmessern) von 0,2 bis 2 mm aufgebracht.

Es kann auch günstig sein, die Element- oder Oxidmischungen in eine Platte mit eckigen Kavitäten als Suspension einzubringen, das Suspensionsmittel (unter vermindertem Druck) abzuziehen, das Material zu schmelzen oder zu sintern und die so erhaltenen kleinen Würfel oder Quader dann zu testen, gegebenenfalls nach Sägen, Schleifen oder Polieren. Die Kavitäten können ebenfalls quaderförmig mit Dimensionen im Millimeterbereich sein. Beispielsweise können quaderförmige Kavitäten mit den Dimensionen 6 x 5 x 9 mm eingesetzt werden.

Ein Vorteil dieser Vorgehensweise liegt darin, dass Größenverhältnisse wie im fertigen Generator oder Peltier-Modul erhalten werden. Eine derartige Platte kann beispielsweise 20 bis 100 Kavitäten enthalten.

Der schnelle und zuverlässige Test der Materialien ist essentiell. Erfindungsgemäß können dazu zwei Analyseverfahren durchgeführt werden:

Die Erfindung betrifft ein Verfahren zur kombinatorischen Herstellung und Testung von Halbleitermaterialien für thermoelektrische Generatoren bei dem man auf einem leitfähigen flächigen Substrat ein Array aus Dots der Halbleitermaterialien mit unterschiedlicher Zusammensetzung erzeugt, das Substrat vorzugsweise unter einem inerten Gas wie Stickstoff oder Argon mit dem Array auf eine gewünschte Meßtemperatur temperiert und die Dots jeweils mit einem gekühlten Meßstift kontaktiert, wobei die Spannung ohne Belastung, Strom und Spannung bei sich verminderndem Lastwiderstand und/oder der Kurzschlußstrom gemessen, nachfolgend gespeichert und ausgewertet werden. Da die Materialproben von vornherein die Temperatur der Substratplatte aufweisen, wird erst beim Aufsetzen des gekühlten Meßstifts ein innerhalb von Sekunden wachsendes Temperaturgefälle erzeugt, das einen als Funktion der Temperaturdifferenz sich ändernden Kurzschlußstrom erzeugt, der gemessen und dessen Verlauf gespeichert wird. Zudem betrifft die Erfindung ein Verfahren zur kombinatoren Herstellung und Testung von Halbleitermaterialien für thermoelektrische Generatoren, bei dem man auf einem leitfähigen flächigen Substrat ein Array aus Dots der Halbleitermaterialien mit unterschiedlicher Zusammensetzung erzeugt, die Dots auf der dem Substrat gegenüberliegenden Seite mit einer leitfähigen unmagnetischen Platte kontaktiert, das Substrat und die Platte bei unterschiedlichen Temperaturen hält und elektrisch miteinander verbindet, wobei die Platte mit einer Magnetfeld - Sonde abgetastet wird und die Messdaten gespeichert und ausgewertet werden.

Für beide Methoden werden die auf dem metallischen bzw. Silizumcarbid - Substrat befindlichen Dots z. B. mittels einer Mikrofeinschleifscheibe auf eine einheitliche Höhe abgeschliffen, und dabei wird gleichzeitig eine ebene Fläche geringer Rauhtiefe geschaffen. Man bringt die Substratplatte auf eine Messtemperatur und kontaktiert mit einem gekühlten Messstift unter definierter Auflagekraft die Dots.

Umgekehrt ist es auch möglich, die Substratplatte kalt zu lassen und den Meßstift zu heizen. In diesem Fall kann das Heizen elektrisch oder vorzugsweise nicht elektrisch, sondern rein thermisch erfolgen, um das Einkoppeln von Fehlströmen zu verhindern, beispielsweise, indem man einen Infrarotlaser in geeigneter Weise auf den Meßstift fokussiert.

Während der Meßstift aufliegt, werden die Spannung ohne Belastung, Strom und Spannung bei sich verminderndem Lastwiderstand sowie der Kurzschlußstrom gemessen. Eine rechnergesteuerte Meßapparatur benötigt zum Vermessen eines Materials inklusive Verfahren an den nächsten Dot um 10 Sekunden, was pro Tag die Vermessung von ca. 10.000 Dots bei einer Temperatur ermöglicht. Arbeitet man mit mehreren Meßstiften parallel, so können entsprechend mehr Dots vermessen werden. Die Meßwerte und Kurven können gespeichert und grafisch aufbereitet werden, so dass eine grafische Darstellung auf einen Blick die besseren Materialien anzeigt, deren Zusammensetzung man dann mit üblichen Methoden analysiert. Vorzugsweise wird unter Inertgas gearbeitet.

Eine weitere, jedoch berührungslose Testungs- bzw. Auswertevariante besteht darin, dass man auf die Dots, die sich auf der leitfähigen bzw. metallischen Substratplatte befinden, eine weitere leitfähige unmagnetische gekühlte Platte aufbringt und die beiden Platten elektrisch miteinander verbindet. Bei der anliegenden Temperaturdifferenz ist jeder Dot kurzgeschlossen. Der Kurzschlußstrom erzeugt im Dot und in den umliegenden Plattenteilen lokale Magnetfelder. Man rastert die Platte mit einer Magnetfeldsonde - z. B. einer Hallsonde oder einem Squid - ab und speichert die Meßwerte als Funktion der Koordinaten in einem Rechner. Die Stärke des Magnetfelds ist proportional dem Kurzschlußstrom, aus seiner Richtung ergibt sich, ob das Material p- oder n- leitend ist. Die entsprechende grafische Aufbereitung der Meßwerte zeigt die besonders vorteilhaften Dots auf einen Blick.

Mit dieser Methode können 10.000 Dots innerhalb von 5 bis 30 min. vermessen werden, allerdings nur hinsichtlich der Dotierung und des Kurzschlußstroms.

Die Erfindung betrifft auch ein Array aus mindestens 10 unterschiedlichen erfindungsgemäßen Halbleitermaterialien auf einem leitfähigen Substrat.

Die erfindungsgemäßen Materialien werden gemäß dem Stand der Technik, wie er z. B. WO 98/44562, US 5,448,109, EP-A-1 102 334 oder US 5,439,528 dargestellt ist, in Module eingebracht und in diesen in Serie geschaltet.

**Patentansprüche**

1.   Thermoelektrischer Generator oder Peltier-Anordnung mit einem thermoelektrisch aktiven Halbleitermaterial aus mehreren Metallen oder Metalloxiden, **dadurch gekennzeichnet, dass** das thermoelektrisch aktive Material ausgewählt ist

aus einem p- oder n-dotierten Halbleitermaterial aus einer ternären Verbindung der allgemeinen Formel (I)

$$Me_x S^A_y S^B_z \qquad\qquad (I)$$

mit
Me = Al, Ti, Zr, V, Nb, Ta, Cr, Mo, W, Mn, Fe, Co, Ni, Cu oder Ag,
$S^A$, $S^B$ = B, C, Si, Ge, Sb, Se oder Te,

wobei $S^A$ und $S^B$ jeweils aus verschiedenen Gruppen des Periodensystems der Elemente stammen,

x, y, z unabhängig voneinander Werte von 0,01 bis 1 haben,

und wobei der Gewichtsanteil von $S^A$ und $S^B$ zusammen mehr als 30 % beträgt, bezogen auf das gesamte Halbleitermaterial,

ausgenommen ternäre Verbindungen aus $AlB_{12}$ und $SiB_6$,

oder einem Mischoxid der allgemeinen Formel (II)

$$[(CaO)_u \cdot (SrO)_v \cdot (BaO)_w \cdot (1/2\ Bi_2O_3)_x]_f \cdot \frac{2n+a}{2} \cdot (\{k\} \cdot Me^n O_{\frac{n}{2}} \cdot \{2-k\} \cdot Me^{n+a} O_{\frac{n+a}{2}}) \quad (II)$$

mit

Me = Fe, Cu, V, Mn, Sn, Ti, Mo, W

n = ganze Zahl von 1 bis 6,

a =1 oder 2,

f = Zahl von 0,2 bis 5,

k = Zahl von 0,01 bis 2,

u + v + w + x = 1.

**2.** Thermoelektrischer Generator oder Peltier-Anordnung nach Anspruch 1, **dadurch gekennzeichnet, dass** im Halbleitermaterial $S^A$ und $S^B$ ausgewählt sind aus B, C, Ge, Sb und Te.

**3.** Thermoelektrischer Generator oder Peltier-Anordnung nach Anspruch 1 oder 2, **dadurch gekennzeichnet, dass** im Halbleitermaterial Me ausgewählt ist aus Al, Ti und Zr.

**4.** Thermoelektrischer Generator oder Peltier-Anordnung nach Anspruch 1 oder 2, **dadurch gekennzeichnet, dass** im Halbleitermaterial Me ausgewählt ist aus V, Nb und Ta.

**5.** Thermoelektrischer Generator oder Peltier-Anordnung nach Anspruch 1 oder 2, **dadurch gekennzeichnet, dass** im Halbleitermaterial Me ausgewählt ist aus Cr, Mo oder W.

**6.** Thermoelektrischer Generator oder Peltier-Anordnung nach Anspruch 1 oder 2, **dadurch gekennzeichnet, dass** im Halbleitermaterial Me ausgewählt ist aus Mn, Fe, Co und Ni.

**7.** Thermoelektrischer Generator oder Peltier-Anordnung nach Anspruch 1 oder 2, **dadurch gekennzeichnet, dass** im Halbleitermaterial Me ausgewählt ist aus Cu und Ag.

**8.** Thermoelektrischer Generator oder Peltier-Anordnung nach Anspruch 1, **dadurch gekennzeichnet, dass** für das Mischoxid f einen Wert im Bereich von 0,2 bis 0,9 oder 1 oder von 1,01 bis 2 oder von 2,01 bis 5 aufweist.

**9.** Halbleitermaterial, wie es in einem der Ansprüche 1 bis 8 definiert ist.

**10.** Verfahren zur Herstellung von Halbleitermaterialien gemäß Anspruch 9 durch Sintern oder Zusammenschmelzen und nachfolgend Sintern von Mischungen der Elementpulver oder durch Sintern von Mischungen der Oxidpulver.

**11.** Verfahren zur kombinatorischen Herstellung und Testung von Halbleitermaterialien für thermoelektrische Generatoren nach Anspruch 9, bei dem man auf einem leitfähigen flächigen Substrat ein Array aus Dots der Halbleitermaterialien mit unterschiedlicher Zusammensetzung erzeugt, das Substrat mit dem Array auf eine gewünschte Meßtemperatur temperiert und die Dots jeweils mit einem gekühlten oder geheizten Meßstift kontaktiert, wobei die Spannung ohne Belastung, Strom und Spannung bei sich verminderndem Lastwiderstand und/oder der Kurzschlußstrom gemessen, nachfolgend gespeichert und ausgewertet werden.

**12.** Verfahren zur kombinatoren Herstellung und Testung von Halbleitermaterialien für thermoelektrische Generatoren nach Anspruch 9, bei dem man auf einem leitfähigen flächigen Substrat ein Array aus Dots der Halbleitermaterialien mit unterschiedlicher Zusammensetzung erzeugt, die Dots auf der dem Substrat gegenüberliegenden Seite mit einer leitfähigen unmagnetischen Platte kontaktiert, das Substrat und die Platte bei unterschiedlichen Temperaturen hält und elektrisch miteinander verbindet, wobei die Platte mit einer Magnetfeld - Sonde abgetastet wird und die Meßdaten gespeichert und ausgewertet werden.

13. Array aus mindestens 10 unterschiedlichen Halbleitermaterialien gemäß Anspruch 9 auf einem leitfähigen Substrat.